Europäisches Patentamt

European Patent Office

Office européen des brevets

(11) Veröffentlichungsnummer: **0 123 333 B1**

# EUROPÄISCHE PATENTSCHRIFT

(45) Veröffentlichungstag der Patentschrift: **21.11.91**

(51) Int. Cl.⁵: **G06G 7/28**, G06G 7/22

(21) Anmeldenummer: **84200402.0**

(22) Anmeldetag: **21.03.84**

(54) **Verfahren zur Erzeugung eines annähernd sinusförmigen Signals und Schaltungsanordnung zur Durchführung dieses Verfahrens, insbesondere für einen Stereo-Demodulator.**

(30) Priorität: **26.03.83 DE 3311072**

(43) Veröffentlichungstag der Anmeldung:
**31.10.84 Patentblatt 84/44**

(45) Bekanntmachung des Hinweises auf die
Patenterteilung:
**21.11.91 Patentblatt 91/47**

(84) Benannte Vertragsstaaten:
**DE FR GB IT**

(56) Entgegenhaltungen:
**DE-A- 2 739 668**
**US-A- 3 120 605**
**US-A- 3 512 092**

(73) Patentinhaber: **Philips Patentverwaltung GmbH**
**Wendenstrasse 35 Postfach 10 51 49**
**W-2000 Hamburg 1(DE)**

(84) Benannte Vertragsstaaten:
**DE**

Patentinhaber: **N.V. Philips' Gloeilampenfabrieken**
**Groenewoudseweg 1**
**NL-5621 BA Eindhoven(NL)**

(84) Benannte Vertragsstaaten:
**FR GB IT**

(72) Erfinder: **Jansen, Winfried**
**Blütenweg 29**
**W-2081 Ellerbek(DE)**
Erfinder: **Nolde, Wolfgang**
**Im Ginsterbusch**
**W-2000 Hamburg 61(DE)**

(74) Vertreter: **Hartmann, Heinrich, Dipl.-Ing. et al**
**Philips Patentverwaltung GmbH Wendenstrasse 35 Postfach 10 51 49**
**W-2000 Hamburg 1(DE)**

**Beschreibung**

Die Erfindung bezieht sich auf ein Verfahren nach dem Oberbegriff des Anspruch 1 sowie auf eine Schaltungsanordnung zur Durchführung dieses Verfahrens. Ein solches Verfahren ist aus dem Buch von Graeme, Toby und Huelsman: "Operational Amplifiers in Nonlinear Circuits" Mc. Graw-Hill, 1971, Seite 259, Fig. 7.27a, im wesentlichen bekannt. Dabei wird aus einem Dreiecksignal mit Hilfe eines Dioden-Funktionsgenerators, der Kennlinienteile mit unterschiedlicher Steigung aufweist, ein periodisches Signal erzeugt, das eine gewisse Ähnlichkeit mit einer Sinusschwingung aufweist. Ein Nachteil des bekannten Verfahrens besteht u.a. darin, daß das annähernd sinusförmige Ausgangssignal des Dioden-Funktionsgenerators nicht nur seine Amplitude, sondern auch seine Form ändert, wenn sich die Amplitude des zugeführten Dreiecksignals ändert.

Sinusförmige Signale können an sich mit Hilfe von geeigneten Sinusoszillatoren erzeugt werden, jedoch benötigen solche Oszillatoren entweder geeignete Schwingkreiselemente, z.B. Quarze oder Induktivitäten, und können daher mit vertretbarem Aufwand nicht als integrierte Schaltung hergestellt werden. Auf der anderen Seite besteht jedoch insbesondere bei Stereo-Demodulatoren der Wunsch nach einem Signal mit der Frequenz des Pilottons oder des Hilfsträgers mit möglichst sinusförmigem Verlauf.

Ursprünglich wurden dabei Rechtecksignale mit der gewünschten Frequenz verwendet, die jedoch verhältnismäßig stark von der Sinusform abweichen. Insbesondere die darin enthaltene dritte Harmonische der Grundfrequenz verschlechtert die Eigenschaften eines diese Schwingungen benutzenden Demodulators beträchtlich. Aus der DE-OS 27 39 668 ist es bekannt, anstelle eines Rechtecksignals ein Dreiecksignal zu benutzen, dessen dritte Harmonische um den Faktor 3 niedriger ist als bei einem Rechtecksignal. Schließlich ist es aus der US-PS 4,300,019 auch bekannt, ein dreistufiges, periodisches Rechtecksignal zu erzeugen, das so geformt ist, daß keine dritten Harmonischen auftreten. Der Aufwand zur Erzeugung eines solchen Signals ist allerdings relativ hoch, und in einigen Anwendungsfällen, beispielsweise wenn ein sinusförmiges (Pilot-) Signal durch ein anderes Signal kompensiert werden soll, kommt es nicht nur darauf an, daß die dritte Harmonische verschwindet, sondern darüber hinaus auch darauf, daß sein zeitlicher Verlauf möglichst exakt dem eines Sinussignals entspricht.

Die US-A- 3 120 605 beschreibt einen Funktionsgenerator dessen Übertragungsfunktion f(X) annähernd mit Hilfe von Dreieckssignalen erzeugt wird.

Aufgabe der vorliegenden Erfindung ist daher ein Verfahren zum Erzeugen eines Signals, dessen zeitlicher Verlauf weitgehend dem eines sinusförmigen Signals entspricht, aus Dreiecksignalen.

Zwei Lösungen dieser Aufgabe sind in den Ansprüchen 1 und 2 beschrieben.

Das Überlagerungssignal hat dabei die Form einer durch Geraden approximierten, sich periodisch wiederholenden Glockenkurve. Dadurch, daß jede zweite Schwingung, d.h. jede zweite Glockenkurve invertiert wird, ergibt sich ein Signal, das zu den Zeitpunkten $nT/8$ ($n =$ eine ganze Zahl, $T =$ Periodendauer des Signals) exakt einem sinusförmigen Signal entspricht, und der übrige Verlauf dieses Signals ergibt sich als linear ansteigender bzw. abfallender Verlauf zwischen den Amplitudenwerten an den genannten Punkten.

Ein derartiges Signal weist keine geradzahlige Harmonische und keine dritte und fünfte Harmonische auf; die siebte und die neunte Harmonische sind nur schwach ausgeprägt.

Ein Vorteil dieses Verfahrens bei seiner Anwendung in einem Stereodemodulator besteht darüberhinaus darin, daß bei den bisher bekannten integrierten Schaltungen zur Stereodemodulation (z.B. TDA 1578) die erforderlichen Dreieckschwingungen und etwaige weitere Hilfssignale ohnehin schon zur Verfügung stehen.

Eine Schaltung zur Durchführung der ersten Variante des erfindungsgemäßen Verfahrens ist in Anspruch 5 angegeben. Da dabei von dem ersten Umschalter nur ein Ausgangssignal benötigt wird, kann stattdessen auch ein Schalter verwendet werden.

Eine vorteilhafte Ausgestaltung dieser Schaltung ist in Anspruch 6 angegeben.

Die Subtraktion der Ausgangssignale des zweiten Umschalters kann in besonders einfacher Weise dadurch erfolgen, daß mit dem Kollektor des einen der den Zweiten Umschalter bildenden Transistoren der Eingang einer Stromspiegelschaltung verbunden ist, deren Ausgang mit dem Kollektor des anderen Transistors verbunden ist. An dem Kollektor des einen, den zweiten Umschalter enthaltenden Transistors, der mit dem Ausgang der Stromspiegelschaltung verbunden ist, ergibt sich dabei ein Strom, der den angegebenen zeitlichen Verlauf hat.

Eine Schaltung zur Durchführung der zweiten Alternative des erfindungsgemäßen Verfahrens ist in Anspruch 7 angegeben.

Aufgrund des geschilderten weitgehend sinusförmigen Verlaufes des mit dem erfindungsgemäßen Verfahren bzw. der erfindungsgemäßen Schaltung erzeugten Signals ist dieses Verfahren bzw. diese Schaltung besonders zur Anwendung in einem Empfänger zur Kompensation des in einem empfangenen Stereosignal enthaltenden Pilotsignals geeignet, und zwar insbesondere dann, wenn das vom Pilotsignal befreite Signal anschließend einer Störaustastschaltung zugeführt, die aus einem von einem Störungsdetektor gesteuerten Schalter im Querzweig und einem Speicherkondensator besteht. Bei einer solchen Schaltung ist es nämlich wichtig, daß das Signal, das das empfangene Pilotsignal kompensieren soll, möglichst genau sinusförmig ist.

Die Erfindung wird nachstehend anhand der Zeichnung näher erläutert. Es zeigen

Fig. 1    ein Blockschaltbild eines Teils eines Stereoempfängers, in dem die erfindungsgemäße Schaltung anwendbar ist,

Fig. 2    ein Schaltbild der darin enthaltenen erfindungsgemäßen Schaltung, und

Fig. 3a bis 3i    die zeitlichen Verläufe der Signale an den Punkten a bis i der Schaltung nach Fig. 2,

Fig. 4    eine andere Ausführungsform,

Fig. 5k bis 5s    den zeitlichen Verlauf der bei Fig. 4 auftretenden Signale.

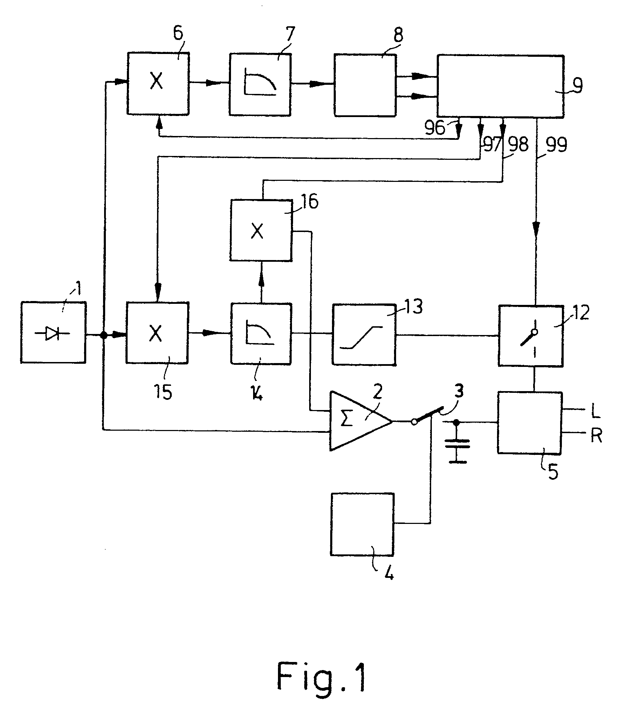

Der in Fig. 1 dargestellte Schaltungsteil enthält einen FM-Demodulator 1, dessen Ausgangssignal über eine Summier- bzw. Subtrahierschaltung 2 einem Schalter 3 zugeführt wird, dessen Schaltzustand von einem Störungsdetektor 4 so gesteuert wird, daß im Normalbetrieb der Schalter 3 geschlossen und im Störungsfall geöffnet ist. Der unmittelbar vor der Störung auftretende Wert der Ausgangsspannung wird von einem Speicherkondensator gespeichert, dessen Spannung dem Eingang eines Stereodemodulators 5 zugeführt wird.

Der Hilfsträger für diesen Stereodemodulator wird von einer PLL-Schaltung erzeugt, die an den Ausgang des FM-Demodulators angeschlossen ist. Sie enthält eine Phasenvergleichsstufe in Form einer Multiplizierschaltung 6, deren Ausgangssignal durch ein Tiefpaßfilter 7 gefiltert wird, dessen Ausgangssignal seinerseits die Frequenz eines spannungsgesteuerten 76 kHz-Rechteckoszillators 8 steuert, dessen Ausgangssignal einer Schaltung 9 zugeführt wird, die das Oszillatorsignal in der Frequenz teilt und formt. Ein Ausgang 96 der Schaltung 9, der ein 19 kHz-Signal liefert, ist mit einem zweiten Eingang der Multiplizierschaltung 6 verbunden. Wenn die den beiden Eingängen der Multiplizierschaltung 6 zugeführten Signale dieselbe Frequenz und eine um 90° Grad verschobene Phase haben (so daß die Nulldurchgänge des einen Signals um eine Viertelperiode gegenüber den Nulldurchgängen des anderen Signals versetzt sind), ist die Ausgangsspannung der Multiplizierschaltung Null und die Frequenz des Oszillators behält ihren Momentanwert bei. In allen anderen Fällen wird durch das dann von Null verschiedene Ausgangssignal der Multiplizierschaltung 6 die Frequenz des Oszillators 8 so gesteuert, daß sich die angegebenen Frequenz- und Phasenbedingungen ergeben.

Die Schaltung 9 liefert an einem Ausgang 99 ein 38 kHz-Signal, dessen Flanken mit Nulldurchgängen des Pilotsignals zusammenfallen. Dieses Rechtecksignal wird einem steuerbaren Schalter 12 zugeführt, dessen Ausgang mit dem Hilfsträgereingang des Stereodemodulators 5 verbunden ist.

Die Steuerung des Schalters 12 erfolgt durch einen Schwellwertschalter 13, dessen Eingang über ein Tiefpaßfilter 14 mit einer zweiten Multiplizierschaltung 15 verbunden ist, die das Ausgangssignal des FM-Demodulators mit dem Ausgangssignal an einem Ausgang 97 der Schaltung 9 multipliziert. An diesem Ausgang steht ein 19 kHz-Rechtecksignal, dessen Flanken im stationären Zustand mit den Nulldurchgängen des Pilotsignals am Ausgang des FM-Demodulators zusammenfallen. Das Ausgangssignal der Multiplizierschaltung hängt daher nur noch von der Amplitude des in dem Demodulator-Ausgangssignal enthaltenen Pilotsignals ab - und zwar ist es um so größer, je größer die Amplitude des Pilotsignals ist. Unterschreitet die Amplitude des Ausgangssignals der Multiplizierschaltung 15 einen bestimmten Wert, wird über den Tiefpaß 14 und den Schwellwertschalter 13 der Schalter 12 geöffnet, so daß das empfangene Signal nur noch monaural verarbeitet werden kann. Ist die Amplitude des Ausgangssignals hingegen größer, wird der Schalter 12 geschlossen, so daß ein stereophoner Empfang möglich ist. Grundsätzlich ist auch ein gleitender Mono-Stereo-Übergang möglich, was allerdings den Ersatz des Schalters 12 und des ihn steuernden Schwellwertschalters 13 durch stetig wirkende Übertragungsglieder voraussetzt.

An einem vierten Eingang 98 der Schaltung 9 erscheint das zu erzeugende, nahezu sinusförmige Signal, dessen Frequenz mit derjenigen des Pilotsignals identisch ist und dessen Nulldurchgänge mit denen des Pilotsignals am Ausgang des FM-Demodulators 1 zusammenfallen. Dieses Signal wird einer weiteren Multiplizierstufe 16 zugeführt, deren Übertragungsfaktor durch das Ausgangssignal des Tiefpasses 14 so gesteuert wird, daß die Amplitude des Ausgangssignals der Schaltung 16 der Amplitude des im empfangenen Signal enthaltenen Pilotsignals entspricht. Das Ausgangssignal wird einem zweiten Eingang der Schaltung 2 zugeführt und darin zu dem Pilotsignal addiert (falls das Pilotsignal und das Ausgangssignal der Multiplizierschaltung jeweils die gleiche Polarität haben; im anderen Fall werden die beiden Signale voneinander subtrahiert).

Aufgrund dieser Kompensation enthält das Ausgangssignal der Schaltung 2 kein Pilotsignal mehr, so daß die Reststörungen, die anderenfalls beim Öffnen des Schalters 3 auftreten würden (vgl. DE-PS 20 52 098) nicht auftreten können und Mittel zur Beseitigung dieser Reststörung - z.B. ein auf 19 kHz abgestimmter Parallel-Schwingkreis in Serie zum Speicherkondensator - überflüssig sind.

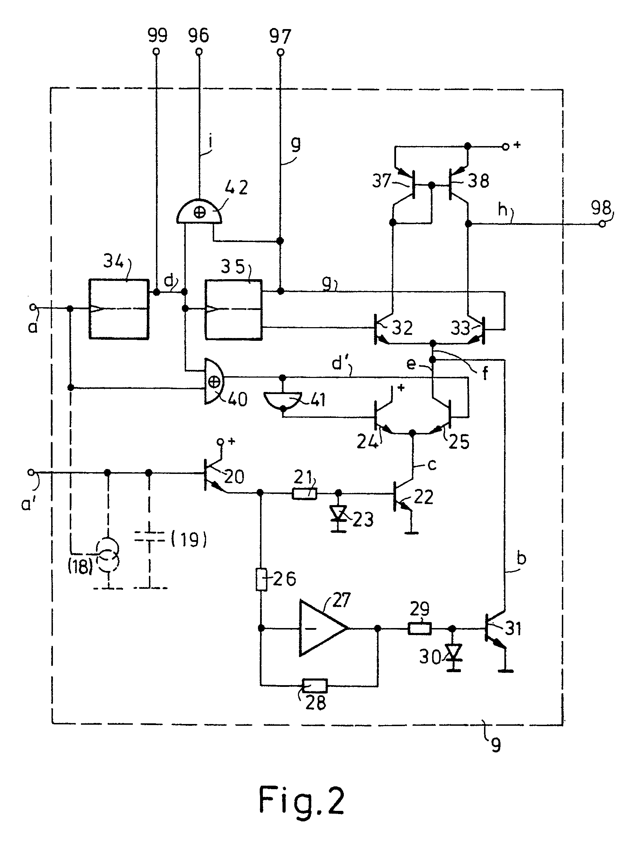

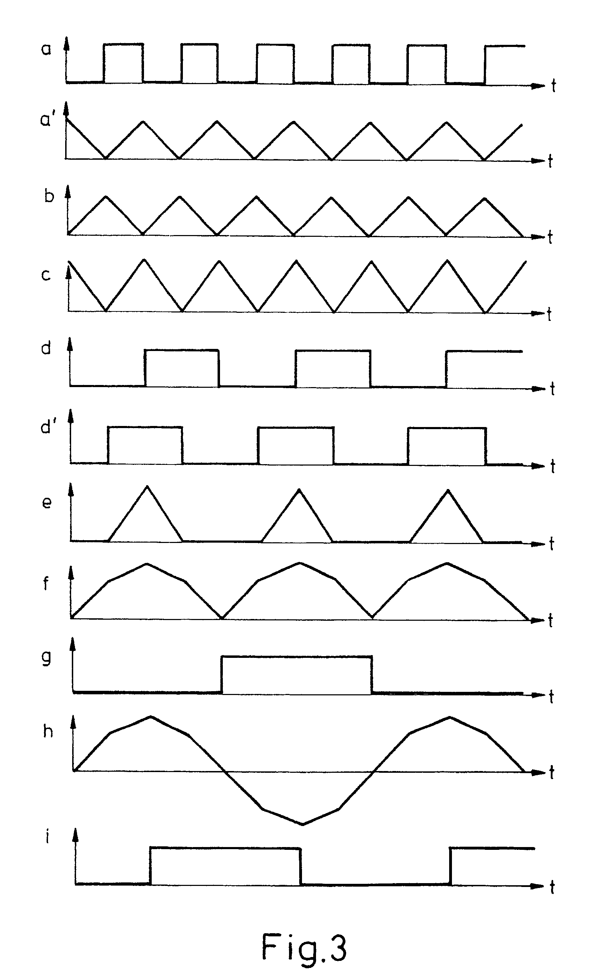

Der Aufbau der Schaltung 9 geht aus Fig. 2 hervor. Dem Eingang a dieser Schaltung wird das 76 kHz-Rechtecksignal (vgl. Fig. 3a) des in der Frequenz steuerbaren Oszillators 8 zugeführt. Es steuert eine umschaltbare Stromquelle 18, die einen Kondensator 19 entweder auflädt oder entlädt, wobei Aufladestrom und Entladestrom einander gleich sind. Am Kondensator 19 entsteht mithin eine symmetrische Dreieckspannung. - Bei vielen Stereo-Demodulatoren werden spannungsgesteuerte Oszillatoren mit geschalteten Stromquellen benutzt. Dabei wird eine externe Kapazität mit einer Stromquelle geladen, die bei Erreichen des Spannungsendwertes am Kondensator das Vorzeichen wechselt. Bei Verwendung eines solchen Oszillators müßte das dreieckförmige Signal nicht erst in der Schaltung 9 erzeugt werden; wie gestrichelt angedeutet, könnten dann die Stromquelle 18 und der Kondensator 19 entfallen und das Dreiecksignal müßte dann dem Eingang a' der Schaltung 9 zugeführt werden.

Dieses Eingangssignal bzw. die Spannung am Kondensator 19 wird der Basis eines als Emitterfolger geschalteten Transistors 20 zugeführt, dessen Emitter über einen Widerstand 21 mit der Basis eines Transistors 22 verbunden ist, dessen Emitter mit Masse verbunden ist. Parallel zur Basis-Emitter-Strecke 22 liegt eine Diode 23 die in integrierter Schaltungstechnik als Transistor mit kurzgeschlossener Basis-Kollektor-Strecke ausgebildet ist und die gleiche Kennlinie hat wie die Basis-Emitter-Strecke des Transistors 22. Sie bildet mit diesem zusammen einen Stromspiegel, der den durch den Widerstand 21 bestimmten Dreieck-Eingangsstrom in einen entsprechenden Ausgangsstrom (Fig. 3c) am Kollektor c des Transistors umsetzt.

Der Kollektor des Transistors 22 ist mit einem ersten Umschalter verbunden, der durch zwei npn-Transistoren 24 und 25 gebildet wird, deren Emitter miteinander und mit dem Kollektor des Transistors 22 verbunden sind. Der Kollektor des Transistors 24 ist an eine positive Speisespannung angeschlossen. Die beiden Transistoren 24 und 25 werden im Gegentakt durch eine 38 kHz-Rechteckspannung leitend gemacht und gesperrt (Fig. 3d'), die von einem Exklusiv-Oder-Gatter 40 erzeugt wird, dessen Ausgang mit der Basis des Transistors 25 direkt und mit der Basis des Transistors 24 über ein Negationsglied 41 verbunden ist. Das Eingangssignal am Eingang a wird einem der Eingänge dieses Exklusiv-Oder-Gatters direkt zugeführt und dem anderen Eingang über ein durch die negativen Flanken des Eingangssignals geschaltetes Flip-Flop 34. Der Ausgang des Flip-Flops 34 bildet überdies den Ausgang 99 der Schaltung 9. Das Signal an diesem Ausgang ist in Fig. 3d dargestellt.

Diese Steuerung der Transistoren 24 und 25 bewirkt, daß im Kollektorstrom eines der Transistoren 24 und 25 jeweils eine von zwei aufeinanderfolgenden Dreieckschwingungen unterdrückt wird, so daß sich am Kollektor e des Transistors 25 der Fig. 3e dargestellte zeitliche Stromverlauf ergibt.

Mit dem Emitter des Transistors 20 ist außerdem über einen Widerstand 26 der invertierende Eingang eines Operationsverstärkers 27 verbunden, dessen Ausgang über einen Widerstand 28 mit dem invertierenden Eingang verbunden ist. Die Widerstände 26 und 28 verhalten sich wie $\sqrt{2}:1$, so daß das Ausgangssignal des Operationsverstärkers um den Faktor $\sqrt{2}$ kleiner ist als das Signal am Emitter des Transistors 20 und außerdem um 180° gegenüber diesem Signal in der Phase versetzt. Dieses Signal wird über einen Widerstand 29 einem Stromspiegel zugeführt, der aus einer Diode 30 und der dazu parallelgeschalteten Basis-Emitter-Strecke eines Transistors 31 besteht, dessen Kollektor mit dem Kollektor des Transistors 25 verbunden ist. Der Strom am Kollektor b des Transistors 31 hat daher den in Fig. 3b dargestellten Verlauf; er ist also gegenüber dem Strom am Kollektor des Transistors 22 (Fig. 3c) um den Faktor $\sqrt{2}$ kleiner und außerdem um 180° in der Phase gedreht. Dieses Ergebnis läßt sich auch durch eine andere Schaltung erreichen; beispielsweise kann der Umkehrverstärker 26...28 die Verstärkung -1 aufweisen, wenn der Widerstand 29 um den Faktor $\sqrt{2}$ größer ist als der Widerstand 21.

Die miteinander verbundenen Kollektoren der Transistoren 25 und 31 sind mit einem zweiten Umschalter verbunden, der durch die npn-Transistoren 32 und 33 gebildet wird, deren Emitter miteinander und mit den genannten Kollektoren verbunden sind. Der den beiden Emittern zugeführte Gesamtstrom am gemeinsamen Verbindungspunkt f der Fig. 2 hat den in Fig. 3f dargestellten zeitlichen Verlauf, der ein periodisches annähernd glockenförmiges Signal mit einer Frequenz von 38 kHz darstellt.

An dieser Stelle sei bemerkt, daß die Gleichstromanteile nicht maßstabsgetreu dargestellt sind. Dies ist jedoch unwesentlich, weil der Gleichstromanteil durch die weitere Schaltung ohnehin eliminiert wird.

Der aus den Transistoren 32 und 33 bestehende Umschalter wird durch eine 19 kHz-Spannung gesteuert, die aus dem Ausgangssignal des Flip-Flops 34 mit Hilfe eines nachgeschalteten, ebenfalls auf die negativen Flanken ansprechenden Flip-Flops 35 erzeugt wird. Die Signale an den beiden zueinander komplementären Ausgänge des Flip-Flops 35 sind Rechtecksignale, deren Flanken mit den Nulldurchgängen des zu erzeugenden annähernd sinusförmigen Signals bzw. mit den Nulldurchgängen des im Ausgangssignals des FM-Demodulators 1 enthaltenen Pilotsignals zusammenfallen. Das Signal von einem dieser Eingänge (Kurvenverlauf g) wird dem Ausgang 97 der Schaltung 9 zugeführt und gleichzeitig dem einen Eingang einer Exklusiv-Oder-Schaltung 42, deren anderer Eingang mit dem Eingang des Flip-Flops 35 bzw. dem Ausgang des Flip-Flops 34 verbunden ist. Der Ausgang der Exklusiv-Oder-Schaltung bildet den Ausgang 96 der Schaltung. An ihm ist ein 19 kHz-Rechtecksignal abnehmbar (Kurvenverlauf Fig. 3i), das gegenüber dem Signal am Ausgang 97 bzw. gegenüber dem Pilotsignal um eine viertel Periode versetzt ist.

Wie aus Fig. 3f und 3g hervorgeht, fallen die Flanken der Rechteckspannung zwischen den Rasen der Transistoren 32 und 33 mit den Minima des vom Transistor 25 gelieferten Kollektorstroms zusammen, bei denen der zeitliche Differentialquotient dieses Signals seinen stärksten Sprung aufweist. Infolgedessen fließt über die Kollektor-Emitter-Strecke jedes der beiden Transistoren 32 und 33 jeweils eine von zwei aufeinanderfolgenden Schwingungen des in Fig. 3f dargestellten Stromes - und zwar im Zeitbereich jeweils zwischen den definierten Minima.

Der Kollektor des Transistors 32 ist mit dem Eingang eines Stromspiegels verbunden, der durch die beiden pnp-Transistoren 37 und 38 gebildet wird, von denen der Transistor 37 als Diode geschaltet und mit dem Kollektor des Transistors 32 verbunden ist, während der Kollektor des Transistors 38, dessen Basis-Emitter-Strecke der Diode 37 parallelgeschaltet ist, mit dem Kollektor des Transistors 32 verbunden ist. Die im Gegentakt auftretenden Schwingungen der beiden Kollektorströme der Transistoren 32 und 33 werden dadurch subtrahiert. Am Verbindungspunkt h der Kollektoren der Transistoren 33 und 38, der den Ausgang 98 der Schaltung bildet, ergibt sich daher ein Strom mit dem in Fig. 3h dargestellten Verlauf, der entweder direkt oder über einen geeigneten stromspannungswandler der Multiplizierstufe 16 zugeführt wird.

Während der ersten Achtelperiode der Stromschwingung im Punkt h ändert sich der Strom zeitlich linear von Null bis auf den Wert $\sqrt{2}/2$ (bezogen auf die Amplitude des Kollektot-Wechsel-Stromes des Transistors 22). Während der zweiten Achtelperiode ändert sich der Strom zeitlich linear bis zu dem Wert, der durch das Maximum des Stromes am Punkt c gekennzeichnet ist und der um den Faktor $\sqrt{2}$ größer ist als der Strom am Ende der ersten Periode, d.h. er entspricht dem Strom am Punkt c (von Spitze zu Spitze gemessen). In der dritten Achtelperiode sinkt der Strom wieder linear auf $1/2 \sqrt{2}$ seines Maximalwertes und in der vierten Achtelperiode sinkt er mit noch größerer Steigung auf den Wert Null. In der fünften bis achten Achtelperiode wiederholt sich der beschriebene Vorgang - allerdings mit umgekehrten Vorzeichen. Jeweils zum Zeitpunkt nT/8, wobei n eine ganze Zahl und T die Perioden- dauer ist, entspricht der Stromverlauf also genau demjenigen eines sinusförmigen Wechselstromes mit der gleichen Amplitude. Zwischen diesen Zeitpunkten ist der sinusförmige Verlauf durch eine Gerade approximiert, so daß sich - wie auch der Augenschein zeigt - eine relativ geringe Abweichung von dem ideal sinusförmigen Verlauf ergibt. Außerdem hat die erzeugte Schwingung keine dritten Harmonischen; sie eignet sich daher sehr gut zur Kompensation des sinusförmigen Pilotsignals. - Grundsätzlich könnte der Hilfsträger zur Steuerung des Demodulators 5 in Fig. 1 auf entsprechende Weise erzeugt werden. Allerdings müßte dann der Oszillator 8 die doppelte Frequenz (152 kHz) aufweisen.

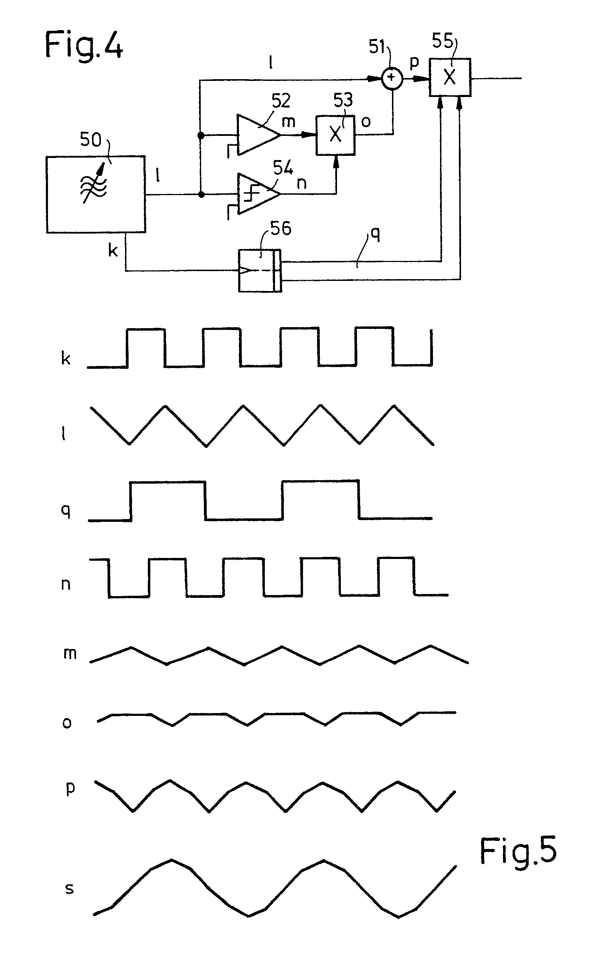

In Fig. 4 ist eine Schaltung dargestellt, die ebenfalls das beschriebene, annähernd sinusförmige Signal erzeugen kann, die dazu jedoch Rechteckspannungen und Dreieck- spannungen mit lediglich der doppelten Frequenz des zu erzeugenden Signals benötigt. Ein Oszillator 50, dessen Frequenz elektronisch steuerbar ist, liefert an einem ersten Ausgang k eine symmetrische Rechteckspannung und an einem zweiten Ausgang l eine symmetrische Dreieckspannung, wobei die Flanken der Rechteckspannung mit den Spitzen, d.h. den Umkehrpunkten der Dreieckspannung, zusammenfallen. Beide Signale sind in Fig. 5 mit k und l bezeichnet. Sie haben die doppelte Frequenz wie das zu erzeugende annähernd sinusförmige Signal. Das Dreiecksignal l wird dem einen Eingang einer Addierschaltung 51 direkt und dem anderen Eingang über einen invertierenden Verstärker 52 und eine Multiplizierstufe 53 zugeführt. Der invertierende Verstärker 52 bildet die Differenz zwischen dem Mittelwert des Dreiecksignals am Eingang und dem Momentanwert des Dreiecksignals. Sein Verstärkungsfaktor ist $2(1-1/\sqrt{2})$, d.h. durch diesen Verstärker wird das Dreiecksignal etwa um den Faktor 1,7 kleiner gemacht als das Dreiecksignal, das dem einen Eingang der Addierschaltung direkt zugeführt wird und außerdem wird es invertiert. Das Ausgangssignal dieses Verstärkers ist in Fig. 5 mit m bezeichnet. In der Multiplizierstufe 53 wird das Ausgangssignal des Verstärkers mit einem Rechtecksignal n multipliziert, das gegenüber dem Signal am Ausgang k des Oszillators um eine viertel Periode in der Phase verschoben ist und das von einer Vergleichsschaltung 54 erzeugt wird, die den Momentanwert des Dreiecksignals mit seinem Mittelwert vergleicht. Infolgedessen hat das Ausgangssignal o der Multiplizierstufe 53 eine Form, die derjenigen des Signals 52 entspricht, wobei jedoch jede zweite (positive) Halbschwingung unterdrückt wird. Wenn die Rechteckspannung am Ausgang der Vergleichsschaltung 54 um 180° in der Phase verschoben wäre, würde die Multiplizierstufe ein Ausgangssignal liefern, bei dem jede negative Halbschwingung des Dreiecksignals m abgeschnitten wäre. Das erhaltene Signal entspricht dem Signal, das sich ergeben würde, wenn von einer Dreieckspannung mit der doppelten Frequenz des Signals l jede zweite Schwingung - jeweils zwischen den positiven bzw. negativen Umkehrpunkten - unterdrückt würde.

Da das Dreiecksignal l und das Ausgangssignal o der Multiplizierschaltung 53 in der Addierschaltung 51 addiert werden, resultiert das Ausgangssignal p, das einer periodischen durch Geraden approximierten Glockenkurve entspricht. - Wenn der Verstärker 52 das Signal nicht invertieren würde, würde sich das gleiche Ausgangssignal p ergeben, wenn die Signale in der Stufe 51 subtrahiert würden.

Das Ausgangssignal p der Addierstufe 51 wird dem einen Eingang einer Multiplizierstufe 55 zugeführt und in dieser mit einer Rechteckspannung q multipliziert, die von den beiden komplementären Ausgängen eines Flip-Flops 56 abgeleitet wird, dessen Eingang die Rechtecksignale k zugeführt werden. Als Multiplizierstufe kann die in Fig. 2 dargestellte und aus den Transistoren 32, 33, 37 und 38 bestehende Schaltung benutzt werden. Da die Flanken der Rechteckspannung q jeweils mit den Minima des Signals p, d.h. mit den Punkten dieses Signals zusammenfallen, in denen der Differentialquotient die stärkste Änderung erfährt, erscheint am Ausgang der Multiplizierschaltung 55 ein Signal s, bei dem gegenüber dem Signal p jede zweite Schwingung invertiert ist.

Ein Vergleich zeigt, daß die Signale e, f, g, h der Fig. 3 mit den Signalen o, p, q und s identisch sind. Die beiden Verfahren bzw. Schaltungen können daher auch miteinander kombiniert werden. Beispielsweise könnte das Dreiecksignal l mit der doppelten Frequenz des zu erzeugenden Signals aus einem Dreiecksignal mit der vierfachen Frequenz abgeleitet werden, indem dieses Dreiecksignal (z.B. das Signal a' in Fig. 3) mit einer Rechteckspannung (d' in Fig. 3) multipliziert wird, deren Frequenz doppelt so groß ist wie die des zu erzeugenden Signals. Ebenso könnte das Signal o aus einer Dreieckspannung mit der vierfachen Frequenz erzeugt werden, von dem jede zweite Schwingung unterdrückt wird.

**Patentansprüche**

1. Verfahren zur Erzeugung eines zeitlich annähernd sinnusförmig verlaufenden Signals (h) aus Dreiecksignalen,
dadurch gekennzeichnet,
- daß ein erstes Signal (e) gebildet wird, das einem Dreiecksignal entspricht, bei dem jede zweite Dreieckschwingung unterdrückt ist, wobei die Periodendauer des ersten Signals halb so groß ist wie die des zu erzeugenden Signals,
- daß ein zweites dreieckförmiges Signal (b) gebildet wird, dessen Frequenz viermal so groß ist wie die des zu erzeugenden Signals (h) und dessen Amplitude um den Faktor $\sqrt{2}$ kleiner ist als die des ersten Signals (e)
- daß die beiden Signale (e, b) derart überlagert werden, daß das Überlagerungssignal (f) sich zeitlich linear in einer ersten Achtelperiode von Null bis zu einem ersten Wert, in der folgenden Achtelperiode bis zum Maximalwert, der um den Faktor $\sqrt{2}$ größer ist als der erste Wert, in der folgenden Achtelperiode zurück zum ersten Wert und in der darauf folgenden Achtelperiode wieder bis zu Null ändert,
- und daß von dem so gebildeten Überlagerungssignal (f) jede zweite Schwingung invertiert wird.

2. Verfahren zur Erzeugung eines zeitlich annähernd sinusförmig verlaufenden Signals (s) aus Dreiecksignalen,
dadurch gekennzeichnet,
- daß ein erstes Signal (o) gebildet wird, das einem Dreiecksignal entspricht, bei dem jede zweite Dreieckschwingung unterdrückt ist, wobei die Periodendauer des ersten Signals halb so groß ist wie die des zu erzeugenden Signals,
- daß ein Zweites dreieckförmiges Signal (l) gebildet wird, dessen Frequenz doppelt so groß ist wie die des zu erzeugenden Signals (s) und dessen Amplitude um den Faktor $2 + \sqrt{2}$ größer ist als die des ersten Signals (o),
- daß die beiden Signale (o, l) derart überlagert werden, daß das Überlagerungssignal (p) sich zeitlich linear in einer ersten Achtelperiode von Null bis zu einem ersten Wert, in der folgenden Achtelperiode bis zum Maximalwert, der um den Faktor $\sqrt{2}$ größer ist als der erste Wert, in der folgenden Achtelperiode zurück zum ersten Wert und in der darauf folgenden Achtelperiode wieder bis zu Null ändert

- und daß von dem so gebildeten Überlagerungssignal (p) jede zweite Schwingung invertiert wird.

3. Verfahren nach einem der vorhergehenden Ansprüche,
dadurch gekennzeichnet, daß das erste Signal (e, o) aus einem ersten Dreiecksignal (c) mit der vierfachen Frequenz des zu erzeugenden Signals abgeleitet wird, indem von diesem Dreiecksignal (c) jede zweite zwischen zwei Minima oder zwei Maxima liegende Dreieckschwingung unterdrückt wird.

4. Verfahren nach einem der Ansprüche 1 oder 2,
dadurch gekennzeichnet, daß das erste Signal (o) aus einer Dreieckschwingung (m) mit der doppelten Frequenz des zu erzeugenden Signals und der doppelten Amplitude des ersten Signals abgeleitet wird, bei der jede zweite Halbschwingung mit einer bestimmten Polarität unterdrückt wird.

5. Schaltungsanordnung zur Erzeugung eines zeitlich sich annähernd sinusförmig veränderten Signals aus Dreiecksignalen,
dadurch gekennzeichnet, daß ein erstes Dreiecksignal (c), dessen Frequenz viermal so groß ist wie die des zu erzeugenden Signals (h), einem ersten Umschalter (24, 25) zugeführt ist, der mit der doppelten Frequenz des zu erzeugenden Signals und jeweils entweder im Minimum oder im Maximum des ersten Dreiecksignals umgeschaltet wird, so daß jede zweite Dreieckschwingung des ersten Dreiecksignals (c) unterdrückt wird, und daß das Ausgangssignal (e) des ersten Umschalters mit einem zweiten Dreiecksignal (b), dessen Frequenz viermal so groß ist wie die des zu erzeugenden Signals und dessen Amplitude um den Faktor √2 kleiner ist als die des ersten Dreiecksignals (e), derart überlagert wird, daß das Überlagerungssignal sich zeitlich linear in einer ersten Achtelperiode von Null bis zu einem ersten Wert, in der folgenden Achtelperiode bis zum Maximalwert, der um den Faktor √2 größer ist als der erste Wert, in der folgenden Achtelperiode zurück zum ersten Wert und in der darauf folgenden Achtelperiode wieder bis zu Null ändert, und daß das gebildete Überlagerungssignal (f) einem zweiten Umschalter (32, 33) zugeführt ist, der mit der Frequenz des zu erzeugenden Signals jeweils beim Minimum des Überlagerungssignals umgeschaltet wird, so daß die Schwingungen des Überlagerungssignals (f) abwechselnd an je einen der beiden Ausgänge des zweiten Umschalters anstehen, und daß die Ausgangssignale des Umschalters einer Subtrahierschaltung (37, 38) zugeführt werden, die die Differenz (h) dieser Signale bildet.

6. Schaltungsanordnung nach Anspruch 5,
dadurch gekennzeichnet, daß eine erste und eine zweite Stromquelle (22, 31) vorgesehen sind, daß die zweite Stromquelle (22) im Emitterzweig des ersten, durch zwei emittergekoppelte Transistoren (24, 25) gebildeten Umschalters angeordnet ist, daß an den Basisanschlüssen der beiden Transistoren eine erste Rechteckspannung (d') mit der doppelten Frequenz anliegt, deren Flanken entweder mit den Minima oder den Maxima des ersten Dreiecksignals (c) zusammenfallen, daß mit dem Kollektor des einen der Transistoren (25) die erste Stromquelle (31) sowie die beiden Emitter zweier den zweiten Umschalter bildenden Transistoren (32, 33) gekoppelt sind, daß an den Baissanschlüssen der beiden den zweiten Umschalter bildenden Transistoren eine Rechteckspannung (g) mit der Frequenz des zu erzeugenden Signals anliegt, deren Flanken mit der den Minima des den Emittern dieser Transistoren zugeführten Stromes zusammenfallen, und daß das zu erzeugende, sinusförmige Signal (h) aus den Kollektorströmen der beiden Transistoren (32, 33) abgeleitet ist.

7. Schaltungsanordnung zur Erzeugung eines zeitlich sich annähernd sinusförmig verändernden Signals aus Dreiecksignalen,
dadurch gekennzeichnet, daß ein Oszillator (50) vorgesehen ist, der ein symmetrisches Rechtecksignal (k) und ein Dreiecksignal (1) mit der doppelten Frequenz wie das zu erzeugende Signal (s) liefert, wobei jeder Extremwert des Dreiecksignals mit einer Flanke des Rechtecksignals (k) zusammenfällt, daß das Dreiecksignal einer Üerlagerungsschaltung (51) über zwei Kanäle zugeführt wird, daß Mittel (53, 54) vorgesehen sind, die jede Halbschwingung in dem einen Kanal unterdrücken, daß der Übertragungsfaktor in diesem Kanal ungefähr um den Faktor 1,7 kleiner ist als derjenige des anderen Kanals, wobei die Überlagerung derart erfolgt, daß das Überlagerungssignal sich zeitlich linear in einer ersten Achtelperiode von Null bis zu einem ersten Wert, in der folgenden Achtelperiode bis zum Maximalwert, der um den Faktor √2 größer ist als der erste Wert, in der folgenden Achtelperiode zurück zum ersten Wert und in der darauf folgenden Achtelperiode wieder bis zu Null ändert und daß die Überlagerungsschaltung (51) mit einer durch das Rechtecksignal gesteuerten Schaltung (55) zum Invertieren jeder zweiten Schwingung des Überlagerungssignals (p) verbunden ist.

8. Schaltungsanordnung nach Anspruch 7, dadurch gekennzeichnet, daß die Mittel zum Unterdrücken jeder zweiten Halbschwingung eine Vergleichsschaltung (54) enthalten, der das Dreiecksignal (1) zugeführt wird und die ein Rechtecksignal (n) erzeugt, dessen Flanken mit dem Zeitpunkt zusammenfallen, in dem der Momentanwert des Dreiecksignals seinen Mittelwert erreicht hat, und daß der eine Kanal eine Multiplizierstufe (53) enthält, die das Dreiecksignal (m) und das Ausgangssignal (n) der Vergleichsschaltung (54) miteinander multipliziert.

9. Schaltungsanordnung nach einem der vorhergehenden Ansprüche, gekennzeichnet durch ihre Anwendung in einem Empfänger zur Kompensation des in einem empfangenen Stereosignal enthaltenen Pilotsignals durch das sinusähnliche Signal.

10. Schaltungsanordnung nach Anspruch 9, dadurch gekennzeichnet, daß das vom Pilotsignal befreite Signal einer Störaustastschaltung zugeführt wird, die lediglich aus einem Schalter (3) im Längszweig und einem Kondensator (4) im Querzweig besteht.

## Claims

1. A method of generating an approximately sinusoidal signal (h) varying with time from triangular signals, characterized in that
   - a first signal (e) is formed which corresponds to a triangular signal in which every second triangular period is suppressed, the period duration of the first signal being half as large as that of the signal to be generated,
   - a second, triangular signal (b) is formed whose frequency is four times as large as that of the signal (h) to be generated and whose amplitude is smaller than that of the first signal (e) by the factor of $\sqrt{2}$,
   - the two signals (e,b) are superimposed on each other in such a way that the superimposition signal (f) varies linearly with time from zero to a first value in a first eighth period, in the subsequent eighth period to the maximum value exceeding the first value by the factor of $\sqrt{2}$, back to the first value in the subsequent eighth period and to zero again in the then subsequent eighth period,
   - and in that every second period of the superimposition signal (f) thus formed is inverted.

2. A method of generating an approximately sinusoidal signal (s) varying with time from triangular signals, characterized in that
   - a first signal (o) is formed which corresponds to a triangular signal in which every second triangular period is suppressed, the period duration of the first signal being half as large as that of the signal to be generated,
   - a second, triangular signal (l) is formed whose frequency is twice as large as that of the signal (s) to be generated and whose amplitude is larger than that of the first signal (o) by the factor of $2 + \sqrt{2}$,
   - the two signals (o,l) are superimposed on each other in such a way that the superimposition signal (p) varies linearly with time from zero to a first value in a first eighth period, in the subsequent eighth period to the maximum value exceeding the first value by the factor of $\sqrt{2}$, back to the first value in the subsequent eighth period and to zero again in the then subsequent eighth period,
   - and in that every second period of the superimposition signal (p) thus formed is inverted.

3. A method as claimed in any one of the preceding Claims, characterized in that the first signal (e, o) is derived from a first triangular signal (c) of four times the frequency of the signal to be generated by suppressing every second triangular period of this triangular signal (c) lying between two minima or two maxima.

4. A method as claimed in Claim 1 or 2, characterized in that the first signal (o) is derived from a triangular period (m) of twice the frequency of the signal to be generated and of twice the amplitude of the first signal, with every second half period of a certain polarity being suppressed.

5. A circuit arrangement for generating an approximately sinusoidal signal varying with time from triangular signals, characterized in that a first triangular signal (c) whose frequency is four times as large as that of the signal (h) to be generated is applied to a first changeover switch (24, 25) which is switched each time at either the minimum or the maximum of the first triangular signal at twice the frequency of the signal to be generated so that every second triangular period of the first triangular signal (c) is suppressed, in that the output signal (e) of the first changeover switch is superimposed on a second triangular signal (b), whose frequency is four times as large as that of the signal to be generated and whose amplitude is smaller than that of the first triangular signal (e) by the factor of $\sqrt{2}$, such that the superimposition signal varies linearly with time from zero to a first value in a first eighth period, in the subsequent eighth period to the maximum value exceeding the first value by the factor of $\sqrt{2}$, back to the first value in the subsequent eighth period and to zero again in the then subsequent eighth period, and in that the superimposition signal (f) formed is applied to a second changeover switch (32, 33) which is switched each time at the minimum of the superimposition signal at the frequency of the signal to be generated, so that the periods of the superimposition signal (f) are each time alternately present at one of the two outputs of the second changeover switch, and in that the output signals of the changeover switch are applied to a subtractor circuit (37, 38) which forms the difference (h) of these signals.

6. A circuit arrangement as claimed in Claim 5, characterized in that a first and a second power source (22, 31) are provided, in that the second power source (22) is arranged in the emitter branch of the first changeover switch formed by two emitter-coupled transistors (24, 25), in that a first square-wave voltage (d') of twice the frequency, whose edges coincide either with the minima or the maxima of the first triangular signal (c), is supplied to the base connections of the two transistors, in that the collector of one of the transistors (25) is coupled to the first power source (31) and to the two emitters of two transistors (32, 33) forming the second changeover switch, in that a square-wave voltage (g) of the frequency of the signal to be generated, whose edges coincide with the minima of the current fed to the emitters of these transistors, is supplied to the base connections of the two transistors forming the second changeover switch and in that the sinusoidal signal (h) to be generated is derived from the collector currents of the two transistors (32, 33).

7. A circuit arrangement for generating an approximately sinusoidal signal varying with time from triangular signals, characterized in that an oscillator (50) is provided which supplies a symmetrical square-wave signal (k) and a triangular signal (I) of twice the frequency of the signal (s) to be generated, with each extreme value of the triangular signal coinciding with an edge of the square-wave signal (k), in that the triangular signal is applied to a superimposition circuit (51) *via* two channels, in that means (53, 54) are provided for suppressing each half period in the one channel, the transmission factor in said channel being smaller than that of the other channel by the factor of approximately 1.7, the superimposition being effected in such a way that the superimposition signal varies linearly with time from zero to a first value in a first eighth period, in the subsequent eighth period to the maximum value exceeding the first value by the factor of $\sqrt{2}$, back to the first value in the subsequent eighth period and to zero again in the then subsequent eighth period, and in that the superimposition circuit (51) is connected to a square-wave signal-controlled circuit (55) for inverting every second period of the superimposition signal (p).

8. A circuit arrangement as claimed in Claim 7, characterized in that the means for suppressing every second half period comprise a comparator circuit (54) to which the triangular signal (ℓ) is applied for generating a square-wave signal (n) whose edges coincide with the instant at which the instantaneous value of the triangular signal has attained its mean value, and in that one channel comprises a multiplier stage (53) for multiplying the triangular signal (m) and the output signal (n) of the comparator circuit (54) by each other.

9. A circuit arrangement as claimed in any one of the preceding Claims, characterized by its application in a receiver for compensating the pilot signal in a received stereo signal by the approximately sinusoidal signal.

10. A circuit arrangement as claimed in Claim 9, characterized in that the signal relieved of the pilot signal is applied to an interference blanking circuit comprising a switch (3) in the series branch and a capacitor (4) in the shunt branch.

**Revendications**

1. Procédé pour la production d'un signal (h) variant d'une manière approximativement sinusoïdale dans le temps à partir de signaux triangulaires,
    caractérisé en ce
    - qu'un premier signal (e) est formé, qui correspond à un signal triangulaire, dans lequel chaque seconde oscillation triangulaire est supprimée, la durée de période du premier signal étant égale à la moitié de celle du signal à produire,

- qu'un second signal triangulaire (b) est formé, dont la fréquence vaut le quadruple de celle du signal (h) à produire et dont l'amplitude est inférieure du facteur $\sqrt{2}$ à celle du premier signal (e),

- que les deux signaux (e, b) sont superposés de manière telle que le signal de superposition (f) varie linéairement dans le temps, au cours d'un premier huitième de période, de zéro jusqu'à une première valeur, dans le huitième de période suivant, jusqu'à une valeur maximale, qui est supérieure du facteur $\sqrt{2}$ à la première valeur, dans le huitième de période suivant, à nouveau vers la première valeur et dans le huitième de période suivant, à nouveau jusqu'à zéro,

- et que chaque seconde oscillation du signal de superposition (f) ainsi formé est inversé.

2. Procédé pour la production d'un signal (s) variant d'une manière approximativement sinusoïdale dans le temps à partir de signaux triangulaires,

  caractérisé en ce

  - qu'un premier signal (o) est formé qui correspond à un signal triangulaire dans lequel chaque seconde oscillation triangulaire est supprimée, la durée de période du premier signal étant égale à la moitié de celle du signal à produire,

  - qu'un second signal triangulaire (l) est formé, dont la fréquence vaut le double du signal (s) à produire et dont l'amplitude est supérieure du facteur $2 + \sqrt{2}$ à celle du premier signal (o),

  - que les deux signaux (o, l) sont superposés de manière telle que le signal de superposition (p) varie linéairement dans le temps au cours d'un premier huitième de période, de zéro jusqu'à une première valeur, dans le huitième de période suivant, jusqu'à une valeur maximale, qui est supérieure du facteur $\sqrt{2}$ à la première valeur, dans le huitième de période suivant, à nouveau vers la première valeur et dans le huitième de période suivant, à nouveau jusqu'à zéro,

  - et que chaque seconde oscillation du signal de superposition (p) ainsi formé est inversée.

3. Procédé suivant l'une quelconque des revendications précédentes, caractérisé en ce que le premier signal (e, o) est dérivé d'un premier signal triangulaire (c) de la fréquence quadruple de celle du signal à produire, par le fait que de ce signal triangulaire (c), chaque seconde oscillation triangulaire se trouvant entre deux minima ou deux maxima est supprimée.

4. Procédé suivant la revendication 1 ou 2, caractérisé en ce que le premier signal (o) est dérivé d'une oscillation triangulaire (m) de la fréquence double de celle du signal à produire et de l'amplitude double de celle du premier signal, chaque seconde oscillation d'une polarité déterminée étant supprimée.

5. Montage de circuit pour la production d'un signal variant de manière approximativement sinusoïdale dans le temps à partir de signaux triangulaires, caractérisé en ce qu'un premier signal triangulaire (c), dont la fréquence vaut quatre fois celle du signal à produire (h), est appliqué à un premier commutateur (24, 25) qui est commuté à la fréquence double de celle du signal à produire et chaque fois au minimum ou au maximum du premier signal triangulaire, de sorte que chaque seconde oscillation triangulaire du premier signal triangulaire (c) est supprimée, et que le signal de sortie (e) du premier commutateur est superposé à un second signal triangulaire (b) dont la fréquence vaut quatre fois celle du signal à produire et dont l'amplitude est inférieure du facteur $\sqrt{2}$ à celle du premier signal triangulaire (e), de manière telle que le signal de superposition varie dans le temps linéairement, dans un premier huitième de période, à partir de zéro jusqu'à une première valeur, dans le huitième de période suivant, jusqu'à la valeur maximale, qui est supérieure du facteurs $\sqrt{2}$ à la première valeur, dans le huitième de période suivant, à nouveau vers la première valeur et dans le huitième de période suivant, à nouveau jusqu'à zéro, et que le signal de superposition (f) formé est appliqué à un second commutateur (32, 33) qui est commuté à la fréquence du signal à produire chaque fois lors du minimum du signal de superposition, de sorte que les oscillations du signal de superposition (f) se présentent alternativement à chacune des deux sorties du second commutateur, et que les signaux de sortie du commutateur sont appliqués à un circuit soustracteur (37, 38) qui forme la différence (h) de ces signaux.

6. Montage de circuit suivant la revendication 5, caractérisé en ce qu'une première et une seconde source de courant (22, 31) sont prévues, que la seconde source de courant (22) est installée dans la branche d'émetteur du premier commutateur formé par deux transistors couplés par les émetteurs (24, 25), qu'aux connexions de base des deux transistors est appliquée une première tension rectangulaire (d') de la fréquence double, dont les flancs coïncident avec les minima ou avec les maxima du premier signal triangulaire (c), qu'au collecteur du premier des transistors (25) sont couplés la première source de courant (31) ainsi que les deux émetteurs de deux transistors (32, 33) formant le second commutateur, qu'aux connexions de base des deux transistors formant le second commutateur est appliquée une tension rectangulaire (g) de la fréquence du signal à produire, dont les flancs coïncident avec les minima du courant appliqué aux émetteurs de ces transistors, et que le signal sinusoïdal (h) à produire est dérivé des courants de collecteur des deux transistors (32, 33).

7. Montage de circuit pour la production d'un signal variant de manière approximativement sinusoïdale dans le temps à partir de signaux triangulaires, caractérisé en ce qu'un oscillateur (50) est prévu qui fournit un signal rectangulaire symétrique (k) et un signal triangulaire (l) de la fréquence double de celle du signal (s) à produire, chaque valeur extrême du signal triangulaire coïncidant avec un flanc du signal rectangulaire (k), que le signal triangulaire est appliqué à un circuit de superposition (51) par deux canaux, que des moyens (53, 54) sont prévus qui suppriment chaque demi-oscillation dans un des canaux, que le facteur de transmission dans ce canal est inférieur d'environ le facteur 1,7 à celui de l'autre canal, la superposition s'effectuant grâce au fait que le signal de superposition varie linéairement dans le temps dans un premier huitième de période, à partir de zéro jusqu'à une première valeur, dans le huitième de période suivant, jusqu'à une valeur maximale, qui est supérieure du facteur $\sqrt{2}$ à la première valeur, dans le huitième de période suivant, à nouveau vers la première valeur et dans le huitième de période suivant, à nouveau jusqu'à zéro et que le circuit de superposition (51) est connecté à un circuit (55) commandé par le signal rectangulaire pour inverser chaque seconde oscillation du signal de superposition (p).

8. Montage de circuit suivant la revendication 7, caractérisé en ce que les moyens destinés à supprimer chaque seconde demi-oscillation comprennent un circuit de comparaison (54) auquel le signal triangulaire (l) est appliqué et qui produit un signal rectangulaire (n) dont les flancs coïncident avec l'instant auquel la valeur instantanée du signal triangulaire a atteint sa valeur moyenne, et que l'un des canaux comprend un étage multiplicateur (53) qui multiplie le signal triangulaire (m) et le signal de sortie (n) du circuit comparateur (54) l'un avec l'autre.

9. Montage de circuit suivant l'une quelconque des revendications précédentes, caractérisé par son utilisation dans un récepteur pour compenser le signal pilote contenu dans un signal stéréo reçu par le signal sinusoïdal.

10. Montage de circuit suivant la revendication 9, caractérisé en ce que le signal débarrassé du signal pilote est appliqué à un circuit suppresseur de parasites qui est constitué simplement d'un interrupteur (3) dans la branche longitudinale et d'un condensateur (4) dans la branche transversale.

EP 0 123 333 B1

Fig.1

Fig.2

Fig.3

# Fig.4

# Fig.5